(19) Europäisches Patentamt
European Patent Office
Office européen des brevets

(11) **EP 2 608 348 B1**

(12) **EUROPÄISCHE PATENTSCHRIFT**

(45) Veröffentlichungstag und Bekanntmachung des Hinweises auf die Patenterteilung:
**06.12.2017 Patentblatt 2017/49**

(51) Int Cl.:
*H02J 3/00* (2006.01)     *H01M 10/44* (2006.01)
*H02H 7/18* (2006.01)

(21) Anmeldenummer: **12008361.3**

(22) Anmeldetag: **15.12.2012**

(54) **Debalancierungs-Schutzschaltung für einen Akkupack**

Debalancing protection circuit for a battery pack

Circuit protecteur de décompensation pour une batterie

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.12.2011 DE 102011121940**

(43) Veröffentlichungstag der Anmeldung:
**26.06.2013 Patentblatt 2013/26**

(73) Patentinhaber: **Andreas Stihl AG & Co. KG 71336 Waiblingen (DE)**

(72) Erfinder:
• **Gaul, Henrik**
  **D-73614 Schorndorf (DE)**
• **Liebhard, Gernot**
  **D-71332 Waiblingen (DE)**

(74) Vertreter: **Wasmuth, Rolf et al**
**Patentanwälte**
**Dipl.Ing. W. Jackisch & Partner mbB**
**Menzelstrasse 40**
**70192 Stuttgart (DE)**

(56) Entgegenhaltungen:
**US-A1- 2010 123 434     US-A1- 2010 321 025**
**US-A1- 2011 068 744     US-A1- 2011 248 675**

**Beschreibung**

Die Erfindung betrifft eine Schutzschaltung für eine Vielzahl von in einem Akkupack angeordneten Einzelzellen nach dem Oberbegriff des Anspruchs 1.

In einem Akkupack werden regelmäßig eine Vielzahl von Einzelzellen in Reihenschaltung und/oder Parallelschaltung zusammengeschaltet, um einen Akkupack mit gewünschter Versorgungsspannung und Kapazität bereitzustellen. Die Einzelzellen haben im Neuzustand im Wesentlichen ein gleiches Verhalten und gleiche Kapazität; mit zunehmender Alterung der Zellen durch Temperatureinflüsse, Lagerung und Belastung wird die Leistungsfähigkeit der Einzelzellen voneinander abweichen. Da ein Zellverbund, insbesondere eine Reihenschaltung von Einzelzellen grundsätzlich nur so gut ist wie die schwächste Zelle, sind Maßnahmen vorgesehen, um frühzeitig zu erkennen, dass der Akkupack die geforderten Leistungen nicht mehr bereitstellen kann und ausgetauscht werden muss.

Aus der US 2011/068744 A1, das den Oberbegriff des Anspruchs 1 bildet, ist eine UPS (uninterruptible power supply) bekannt, die aus einer Vielzahl zusammengeschalteter Einzelzellen besteht, wobei jeder Einzelzelle über einen Schalter ein ohmscher Widerstand parallel geschaltet ist. Die Schalter werden in Abhängigkeit einer erfassten Debalancierung des Zellverbundes geöffnet oder geschlossen, wobei die Debalancierung als Spannungsdifferenzwert zwischen einer Einzelzelle mit der größten Spannung und einer Einzelzelle mit der niedrigsten Spannung ermittelt wird. Während der Ladung oder Entladung der UPS werden die Zustände der Zellen abgefragt und der Wert der Debalancierung neu bestimmt. Ein Laden der UPS wird dann abgeschaltet, wenn eine der Zellen die zulässige maximale Spannung erreicht, der Zellverbund eine maximale Spannung erreicht oder eine maximale Temperatur des Zellverbundes überschritten wird.

Es ist ferner bekannt, zur Überwachung eines Zellverbundes aus einer Vielzahl von Einzelzellen jede einzelne Zellspannung einer Überwachungsschaltung zuzuführen, um jede einzelne Zellspannung in ihrer Größe zu erfassen. Die erfassten Spannungen der Einzelzellen werden dann untereinander verglichen, um die maximale Spannungsdifferenz zwischen einer schwächsten Zelle und einer stärksten Zelle festzustellen. Diese Spannungsdifferenz ist eine Größe für die Debalancierung eines Zellverbundes in einem Akkupack; ist die Spannungsdifferenz klein, sind die Einzelzellen des Zellverbundes in einem guten Zustand; wird die Spannungsdifferenz groß, sind Einzelzellen signifikant schwächer als stärkere Zellen, und der Akkupack ist nur noch bedingt einsatzfähig. Überschreitet die Differenzspannung vorgegebene Debalancierungsgrenzen, wird der Akkupack abgeschaltet.

Im Neuzustand eines Zellverbundes kann für eine präzise Überwachung der Debalancierung eines Akkupacks die Debalancierungsgrenze eng angesetzt werden; altert der Zellverbund, wird die Debalancierung größer, der Akkupack ist aber noch einsetzbar. Erst bei Überschreiten vorgegebener Debalancierungsgrenzen muss der Akkupack außer Betrieb genommen werden.

Die Debalancierungsgrenze eines Zellverbundes in einem Akkupack wird danach ausgelegt, welche maximal zulässige Debalancierung im Alterungszustand der Einzelzellen noch zugelassen werden kann; im Neuzustand des Akkupacks ist eine genaue Überwachung aufgrund der großen Debalancierungsgrenzen nicht möglich. Ein beginnender Ausfall einer Einzelzelle bereits im Neuzustand eines Akkupacks kann daher nicht erkannt werden.

Der Erfindung liegt die Aufgabe zugrunde, eine Schutzschaltung für eine Vielzahl von in einem Akkupack angeordneten Einzelzellen anzugeben, bei der auch im Neuzustand eine präzise Überwachung auf Debalancierung des Zellverbundes möglich ist.

Die Aufgabe wird erfindungsgemäß nach den kennzeichnenden Merkmalen des Anspruchs 1 gelöst.

Die über den Ladezustand variable Kennlinie der Debalancierungsgrenze wird im Neuzustand sehr eng ausgelegt, so dass eine im Neuzustand aufgrund eines Fehlers in einer Einzelzelle auftretende Debalancierung sicher erkannt werden kann. Z. B. kann der Akkupack bei im Neuzustand auftretender Debalancierung abgeschaltet werden, damit Folgeschäden vermieden werden.

Die im Neuzustand enge Debalancierungsgrenze wird in Abhängigkeit eines Korrekturwertes über die Betriebsdauer (Lebensdauer) des Akkupacks verändert, wobei der Korrekturwert in Abhängigkeit von zumindest einer Betriebsgröße des Zellverbundes bestimmt wird. Damit ist eine mit der Alterung des Zellverbundes einhergehende Erweiterung der Debalancierungsgrenze möglich, so dass immer eine dem Alterungszustand der Einzelzellen des Zellverbundes angepasste Debalancierungsgrenze gesetzt ist.

Diese Debalancierungsgrenze ist durch die zulässige Differenzspannung zwischen der Spannung der vollsten Einzelzelle und der Spannung der leersten Einzelzelle des Zellverbundes bestimmt. Dabei können zur Änderung dieser Debalancierungsgrenze nicht nur eine, sondern auch mehrere Betriebsgrößen herangezogen werden, die gemeinsam - z. B. nach einem Algorithmus - den verwendeten Korrekturwert zur Veränderung der Debalancierungsgrenze bestimmen.

Vorteilhaft ist die Betriebsgröße eine historische Betriebsgröße, die aus in der Vergangenheit im Betrieb des Zellverbundes gesammelten historischen Werten gebildet ist. So kann z. B. ein über die Betriebszeit des Zellverbundes gebildetes Lastkollektiv als historische Betriebsgröße angesetzt werden oder ein über die Betriebszeit des Zellverbundes gebildetes Temperaturkollektiv.

Da der Ladevorgang des Akkupacks ebenso wie das angewendete Ladeverfahren einen Einfluss auf die Alterung und die Lebensdauer der Einzelzellen in einem Zellverbund hat, ist in Weiterbildung der Erfindung vorgesehen, dass die Ladezeiten mit unterschiedlichen Ladeströmen erfasst und abgespeichert werden, um aus diesen Werten eine historische Betriebsgröße der ausgeführten Ladungen abzuleiten. Zweckmäßig wird dabei der erfasste Ladestrom mit Bezug zur Kapazität des geladenen Zellverbundes normiert.

Es kann auch zweckmäßig sein, die unterschiedlichen Ladeverfahren des Akkupacks festzustellen und zu protokollieren. So kann eine historische Betriebsgröße aus der Häufigkeit der Ausführung eines ersten Ladeverfahrens im Verhältnis zu einem anderen Ladeverfahren gebildet werden.

Neben der Ladung des Akkupacks mit unterschiedlich großen Strömen hat auch die Belastung des Akkupacks mit unterschiedlich großen Lastströmen Einfluss auf die Lebensdauer. Zweckmäßig wird daher eine historische Betriebsgröße aus dem Betrieb des Akkupacks mit unterschiedlichen Arbeitsgeräten abgeleitet, da unterschiedliche Arbeitsgeräte unterschiedliche Lastströme aufweisen können. Wird z. B. mit dem Akkupack eine elektrische Motorkettensäge betrieben, treten um Faktoren höhere Ströme auf (z. B. 40 Ampere) als im Betrieb mit einer Heckenschere (z. B. 4 Ampere).

Einzelzellen eines Zellverbundes altern auch in Abhängigkeit von der gespeicherten Ladungsmenge. Wird nämlich eine Zelle nur teilgeladen und teilentladen, belastet dies die Zelle weniger als wenn sie vollständig geladen und vollständig entladen wird. Daher ist vorgesehen, eine historische Betriebsgröße aus dem Zyklenverhältnis von Vollladung zur Teilladung zu bilden. Die Teilladung eines Zellverbundes entspricht dabei etwa 70% bis 90%, insbesondere 80% der Vollladung des Zellverbundes.

Neben den historischen Betriebsgrößen können auch im momentanen Betrieb des Akkupacks erfasste aktuelle Betriebsgrößen bei der Bildung des Korrekturwertes für die Debalancierungsgrenze berücksichtigt werden. In einfacher Weise kann als aktuelle Betriebsgröße der aktuelle Strom des Zellverbundes, d. h. der aktuelle Ladestrom oder Entladestrom, oder auch die aktuelle Temperatur des Zellverbundes herangezogen werden.

In Weiterbildung der Erfindung wird als Betriebsgröße die in einem Zellverbund und/oder einer Einzelzelle gespeicherte Ladung herangezogen. So können die über eine Betriebsdauer des Akkupacks ermittelten Ladungsmengen des Zellverbundes und/oder der Einzelzelle protokolliert und - zweckmäßig gewichtet - ausgewertet werden und anhand der so erhaltenen Betriebsgröße der Korrekturwert verändert werden.

Wird die - nach Betriebsgrößen korrigierte - Debalancierungsgrenze überschritten, erzeugt die Schutzschaltung ein Signal, das zweckmäßig als Steuersignal zum Abschalten des gesamten Akkupacks durch einen Schalter herangezogen wird. Dieser Schalter ist zweckmäßig ein elektronischer Schalter, insbesondere ein MOSFET.

In vorteilhafter Weiterbildung der Erfindung wird das Signal einer Steuereinheit des Arbeitsgerätes zugeführt, welches aus dem Akkupack betrieben wird. Die Steuereinheit kann nach Auftreten eines Signals den Motor in anderer Weise ansteuern, um z. B. den Laststrom des Akkupacks zu senken. Wird von der Schutzschaltung mehrfach ein Signal aufgrund des wiederholten Überschreitens der Debalancierungsgrenze erzeugt, kann die Steuereinheit das Arbeitsgerät oder auch den Akkupack abschalten.

Vorteilhaft ist die Überwachungsschaltung mit einer Auswerteeinheit verbunden und bildet zusammen mit dieser die Schutzschaltung. Dabei ist die Schutzschaltung, also die Überwachungsschaltung und die Auswerteeinheit, zweckmäßig im Akkupack vorgesehen.

Weitere Merkmale der Erfindung ergeben sich aus den weiteren Ansprüchen, der Beschreibung und der Zeichnung, in der ein nachfolgend im Einzelnen beschriebenes Ausführungsbeispiel der Erfindung dargestellt ist. Es zeigen:

Fig. 1     in schematischer Darstellung einen Akkupack mit einem Zellverbund aus Einzelzellen,

Fig. 2     ein Schaubild der Spannung einer Einzelzelle über dem Ladezustand,

Fig. 3     ein Schaubild einer Kennlinie einer Debalancierungsgrenze in Abhängigkeit vom Ladezustand des Zellverbundes,

Fig. 4     ein Beispiel zur Bildung einer historischen Betriebsgröße,

Fig. 5     in schematischer Darstellung ein elektrisches Arbeitsgerät am Beispiel einer Motorkettensäge,

Fig. 6     in schematischer Darstellung ein elektrisches Arbeitsgerät am Beispiel eines Freischneiders,

Fig. 7     ein weiteres Beispiel zur Bildung einer historischen Betriebsgröße aus über der Betriebszeit des Akkupacks ermittelten Ladezuständen.

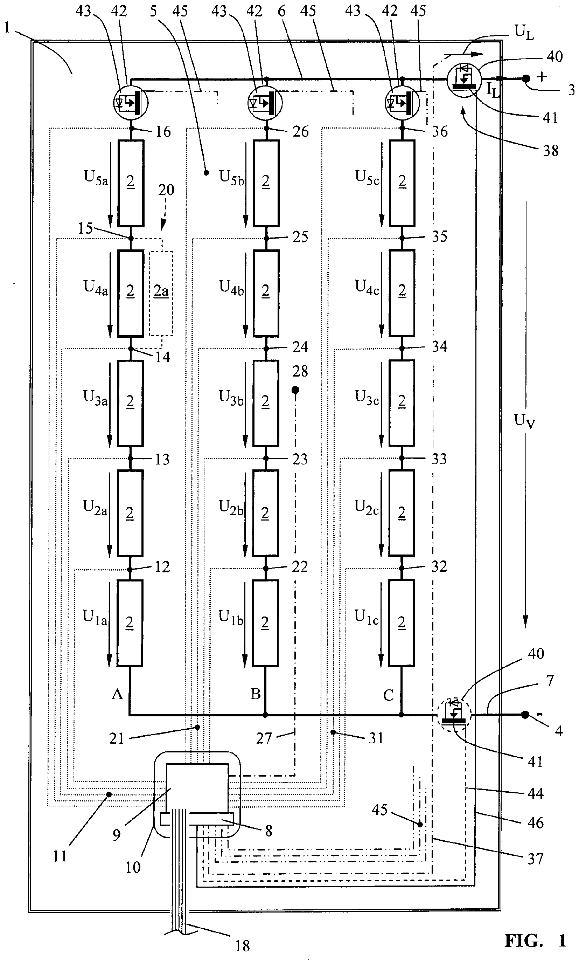

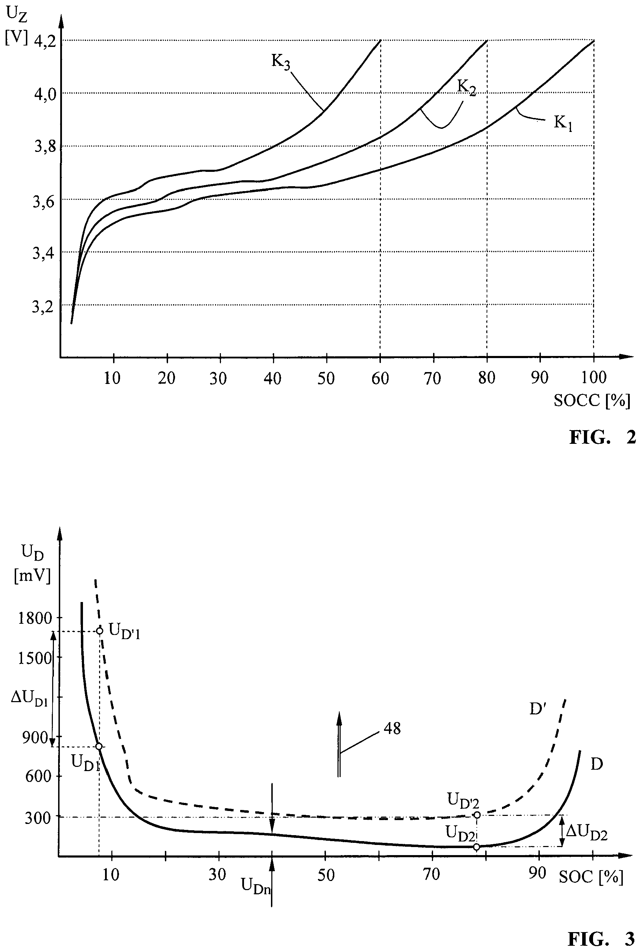

Der in Fig. 1 dargestellte Akkupack 1 besteht aus drei Zellreihen A, B und C, wobei in jeder Zellreihe A, B und C fünf Einzelzellen 2 in Reihenschaltung hintereinander liegen. Jede Einzelzelle 2 jeder Zellreihe A, B und C weist eine Zellspannung $U_{1a}$ bis $U_{5a}$, $U_{1b}$ bis $U_{5b}$ und $U_{1c}$ bis $U_{5c}$ auf. Im gezeigten Ausführungsbeispiel liegen die Zellreihen in Parallelschaltung an den Polen 3, 4, zwischen denen die Versorgungsspannung $U_V$ des Akkupacks 1 abgegriffen wird. Vorteilhaft sind die Einzelzellen 2 chemisch auf Lithium basierende Zellen, z. B. Lithium-Ionen-Zellen, Lithium-Polymer-Zellen, Lithium-Eisen-Zellen oder dgl.; im Ausführungsbeispiel wird von einer Zellspannung von ca. 4,2 Volt bei voller Ladung (Fig. 2) ausgegangen, so dass die maximale Versorgungsspannung $U_V$ ca. 20 Volt beträgt.

Anstelle einer Einzelzelle 2 kann auch ein Zellblock 20 vorgesehen sein, wie in Fig. 1 oben links strichliert angedeutet ist. Ein Zellblock 20 kann aus zwei oder mehr Einzelzellen 2, 2a aufgebaut sein, die - wie im Ausführungsbeispiel gezeigt - elektrisch in Parallelschaltung geschaltet sind und deren Anschlüsse einen gemeinsamen Potenzialpunkt bilden. Die Zellen in einem Zellblock 20 können auch aus mehreren Einzelzellen bestehen, die elektrisch in Parallelschaltung und/oder in Reihenschaltung verschaltet sind.

Die Einzelzellen 2 innerhalb des Zellverbundes 5 können entsprechend der gewünschten Kapazität und der gewünschten Spannung angepasst konfektioniert werden, wobei die Zellen 2 in einer Zellreihe A, B, C sowohl in einer Parallelschaltung, in einer Reihenschaltung oder in Kombination dieser Schaltungen miteinander verbunden sein können.

Die Zellspannungen $U_{na}$, $U_{nb}$ und $U_{nc}$ ($1 \leq n \leq 5$) sind über Signalleitungen 11, 21 und 31 erfasst und werden einer Überwachungsschaltung 9 zugeführt. Hierzu sind die Potenzialpunkte 12 bis 16, 22 bis 26 und 32 bis 36 der Zellen 2 aller Zellreihen A, B, C mit der Überwachungsschaltung 9 verbunden.

Die erfassten Spannungen $U_{na}$, $U_{nb}$ und $U_{nc}$ der Einzelzellen 2 werden in einer Auswerteeinheit 8 ausgewertet, vorteilhaft miteinander verglichen, um die maximale Zellspannung $U_{max}$ und die minimale Zellspannung $U_{min}$ zu ermitteln. Die Differenzspannung $\Delta U_Z = U_{max} - U_{min}$ wird mit einer Debalancierungsgrenze $U_{Dn}$ verglichen, die im System hinterlegt ist.

Abhängig von dem Vergleich der Differenzspannung $\Delta U_Z$ und einer vorgegebenen Debalancierungsgrenze $U_{Dn}$ wird ein Signal erzeugt, welches als Steuersignal zum Abschalten des gesamten Akkupacks 1 und/oder einzelner Zellreihen A, B, C dient. Hierzu ist im Hauptstrang 6 des Pluspols 3 und/oder im Hauptstrang 7 des Minuspols 4 ein gesteuerter Schalter 40 vorgesehen, der im gezeigten Ausführungsbeispiel ein elektronischer Schalter, insbesondere ein MOSFET 41 ist. Entsprechend kann in einer Zellreihe A, B, C ein gesteuerter elektronischer Schalter 42 vorgesehen sein, der zweckmäßig ebenfalls als MOSFET 43 ausgebildet ist. Über Steuerleitungen 44 und 46 werden die elektronischen Schalter 40 von der Schutzschaltung 10 angesteuert, die aus der Überwachungsschaltung 9 und der Auswerteeinheit 8 gebildet ist. Über entsprechende Steuerleitungen 45 können die MOSFET's 43 in den Zellreihen A, B und C von der Schutzschaltung 10 angesteuert sein.

Jede Einzelzelle 2 wird bei Gebrauch des Akkupacks 1 entladen und bei einem Anschluss des Akkupacks 1 an ein Ladegerät wieder geladen. Abhängig vom Ladezustand SOCC (State of Charge Cell) liegt an der Einzelzelle 2 eine Zellspannung $U_Z$ an, wie in Fig. 2 wiedergegeben. Wie die Kennlinie $K_1$ zeigt, liegt die Zellspannung bei leerer Zelle 2 bei ungefähr 3,2 Volt und steigt bei voller Ladung (100% SOCC) bis auf die Ladeschlussspannung von 4,2 Volt an. Altert die Zelle, ändert sich die Kennlinie auf eine Kennlinie $K_2$ oder eine Kennlinie $K_3$; die Zelle wird bei den Kennlinien $K_2$ und $K_3$ nicht mehr vollständig geladen; die Ladeschlussspannung wird bei geringerer Ladung SOCC früher erreicht und führt zum frühzeitigen Abschalten eines Ladevorgangs. Bei einer Entladung brechen gealterte Zellen mit der Zellspannung früher ein als neuwertige Zellen. Im Ausführungsbeispiel der Fig. 2 erreicht eine die mittlere Kennlinie $K_2$ aufweisende gealterte Zelle eine Zellspannung $U_Z = 4,2V$ bereits bei 80% SOCC und eine alte Zelle mit der Kennlinie $K_3$ die Zellspannung $U_Z = 4,2V$ sogar bereits bei einem Ladezustand von 60% SOCC.

Innerhalb eines Zellverbundes 5, wie er in Fig. 1 beispielhaft dargestellt ist, sind eine Vielzahl von Einzelzellen 2 verbaut. Auch wenn die Einzelzellen 2 aus gleicher Fertigung kommen und gleiche Herstellungsdaten tragen, können Sie in ihren Eigenschaften leicht unterschiedlich sein. Sind die Einzelzellen 2 neuwertig, werden deren Zellspannungen $U_{na}$, $U_{nb}$ und $U_{nc}$ sowohl beim Entladen wie beim Laden über ihren Ladezustand nur wenig voneinander abweichen; dies bedeutet, dass eine Differenzspannung $\Delta U_Z$ zwischen einer maximalen Zellspannung $U_{max}$ der Zellspannungen $U_{na}$, $U_{nb}$ und $U_{nc}$ und einer minimalen Zellspannung $U_{min}$ der Zellspannungen $U_{na}$, $U_{nb}$ und $U_{nc}$ klein ist. Für einen typischen Zellverbund 5 ergibt sich im Neuzustand z. B. eine Kennlinie D der Debalancierungsgrenze, die die in einem jeweiligen Ladezustand SOC des Zellverbundes 5 zulässige Differenzspannung $\Delta U_Z$ angibt. Diese zulässige Differenzspannung im Neuzustand des Zellverbundes 5 liegt zwischen ca. 80 mV und ca. 500 mV bei einer Ladung zwischen 10% und 90% SOC (State of Charge).

Altern die Zellen, wird die Differenzspannung $\Delta U_Z$ zwischen der schwächsten Einzelzelle und der stärksten Einzelzelle 2 größer, was dazu führt, dass die Debalancierungsgrenze der unveränderten Kennlinie D häufig überschritten wird, was zu einem Abschalten des Akkupacks 1 führen würde.

Um dies zu verhindern, ist nach der Erfindung vorgesehen, die Kennlinie D in Abhängigkeit eines Korrekturwertes auf eine Kennlinie D' zu verändern. In vorteilhafter Weise gilt z. B.

$$D' = k \cdot D,$$

wobei der Korrekturwert in Abhängigkeit von zumindest einer Betriebsgröße des Zellverbundes 5 gebildet wird. Im Schaubild nach Fig. 3 ist beispielhaft angegeben, wie in Abhängigkeit eines Korrekturwertes k die Kennlinie D zu einer Kennlinie D' verändert wird.

In einfacher Weise wird die Kennlinie D in Pfeilrichtung 48 verschoben, wodurch sich die Debalancierungsgrenze $U_{Dn}$ verschiebt.

Bei etwa 8% Ladezustand des Zellverbundes 5 ergibt sich im Neuzustand eine Debalancierungsgrenze $U_{D1}$ von ca. 800 Millivolt; ein Abschalten des Akkupacks 1 würde also dann erfolgen, wenn unter Last die Zellspannungen $U_{na}$, $U_{nb}$ und $U_{nc}$ der schwächsten und der stärksten Einzelzelle 2 eine Differenzspannung $\Delta U_Z$ von mehr als 800 Millivolt aufweist. Altert der Akkupack, wird unter Berücksichtigung von Betriebsgrößen des Zellverbundes 5 die Kennlinie D auf die Kennlinie D' verändert, so dass dann bei etwa 8% Ladezustand des Zellverbundes 5 im gealterten Zustand eine Debalancierungsgrenze $U_{D'1}$ von ca. 1.700 Millivolt zugelassen wird. Nach Verschieben der Debalancierungsgrenze auf $U_{D'1}$ erfolgt also ein Abschalten des Akkupacks 1 erst dann, wenn die Differenzspannung $\Delta U_Z$ der Zellspannungen der stärksten Zelle und der schwächsten Zelle über 1.700 Millivolt liegt.

Entsprechend erfolgt z. B. bei einem Ladezustand SOC des neuwertigen Zellverbundes 5 von etwa 80% ein Abschalten des Akkupacks bei Überschreiten einer Debalancierungsgrenze von ca. 80 Millivolt; bei der im Laufe des Betriebs sich verändernden Kennlinie wird die Debalancierungsgrenze auf $U_{D'2}$ ansteigen und dann bei altem Zellverbund 5 bei ca. 300 Millivolt liegen. Durch die Anpassung der Debalancierungsgrenze $U_{Dn}$ anhand von Betriebsgrößen des Zellverbundes ergibt sich bei einem Ladezustand SOC von ca. 8% ein Verschieben der Debalancierungsgrenze um $\Delta U_{D1}$ von ca. 900 Millivolt, während im Bereich von ca. 80% Ladezustand SOC sich die Debalancierungsgrenze um $\Delta U_{D2}$ von etwa 200 Millivolt verschiebt.

In einfacher Weise liegt die Debalancierungsgrenze als Kennlinie D vor; die Kennlinie D kann auch als konkrete Kennlinie, als diskrete Werte, als Kennfeld oder als Algorithmus dargestellt sein. Mit dem Begriff "Kennlinie" werden diese und weitere, nicht explizit genannte Ausbildungen und Darstellungen der Debalancierungsgrenze in Abhängigkeit vom Ladezustand SOC zusammengefasst. Der verwendete Korrekturwert k zum Verändern der Kennlinie der Debalancierungsgrenze kann ein Proportionalfaktor oder auch ein

Algorithmus sein. Der Korrekturwert k wird in Abhängigkeit von zumindest einer Betriebsgröße des Zellverbundes 5 gebildet. Um eine gute Anpassung an den Alterungszustand der Einzelzellen 2 zu erreichen, ist vorgesehen, den Korrekturwert k in Abhängigkeit mehrerer Betriebsgrößen zu bilden. Dabei kann die Betriebsgröße eine historische Betriebsgröße HBG sein, die aus in der Vergangenheit im Betrieb des Zellverbundes 5 gesammelten historischen Werten gebildet ist und/oder eine aktuelle Betriebsgröße ABG sein kann, die den Momentanzustand des Zellverbundes 5 im Akkupack 1 wiedergibt. Um den Momentanzustand des Zellverbundes 5 zu erfassen, ist zweckmäßig ein Temperatursensor 28 und/oder ein Sensor 38 zur Erfassung des im Hauptstrang 6, 7 fließenden Laststroms $I_L$ vorgesehen. In einfacher Weise wird der Laststrom $I_L$ über die am elektronischen Schalter 40, nämlich am Innenwiderstand des MOSFET's 41 abfallende Lastspannung $U_L$,

erfasst. Die abfallende Spannung $U_L$ wird über eine Signalleitung 37 der Schutzschaltung 10 zugeführt. In gleicher Weise wird das Signal des Temperatursensors 28 über eine Signalleitung 27 der Schutzschaltung 10 zugeführt. Wird z. B. beim Laden des Zellverbundes 5 ein hoher Strom fließen, so werden Zellen mit einem höheren Innenwiderstand eine größere Zellspannung Uz aufweisen, als Zellen mit einem geringen Innenwiderstand. Bei einem hohen Ladestrom kann somit die Debalancierungsgrenze in Pfeilrichtung 48 verschoben werden, um -fällt der Ladestrom - die Kennlinie D' der Debalancierungsgrenze wieder entgegen Pfeilrichtung 48 im Sinne einer kleineren Debalancierung zurückzuverschieben.

Die erfassten Temperaturwerte des Sensors 38 können über die gesamte Betriebszeit des Akkupacks 1 aufsummiert und in einen Speicher geschrieben werden. Als historische Betriebsgröße kann dann ein aus diesen Werten gebildetes Temperaturkollektiv zur Verschiebung der Debalancierungsgrenze herangezogen werden.

In gleicher Weise können die im Hauptstrang 6, 7 fließenden Lastströme $I_L$ über die gesamte Betriebsdauer (Lebensdauer) des Akkupacks erfasst und abgespeichert werden, um aus diesen gespeicherten Werten ein Lastkollektiv abzuleiten, was zur Verschiebung der Debalancierungsgrenze $U_{Dn}$ genutzt werden kann. Da die Art der Ladung der Einzelzellen 2 des Zellverbundes 5 eine erhebliche Einflussgröße auf die Alterung der Einzelzellen 2 hat, ist in Weiterbildung der Erfindung vorgesehen, die Art des Ladevorgangs zu erfassen, mit der der Zellverbund 5 in der Vergangenheit aufgeladen wurde. So ist von wesentlicher Bedeutung, ob ein Akkupack immer nur mit sehr hohen Strömen geladen oder mit geringeren Strömen geladen wird. Häufiges Laden mit hohen Strömen führt zu einer raschen Alterung der Zellen und damit zu einer größeren Verschiebung der Kennlinie D der Debalancierungsgrenze als Ladevorgänge mit geringeren Strömen. Daher ist vorgesehen, die Ladevorgänge in Abhängigkeit der Größe der Ladeströme zu werten und eine historische Betriebsgröße aus den abgelaufenen Ladezeiten mit unterschiedlichen Ladeströmen zu bilden. Zweckmäßig wird dabei der aufgezeichnete Ladestrom in Bezug zur Kapazität des geladenen Zellverbunds normiert, da ein Zellverbund 5 mit einer höheren Kapazität ohne Schaden mit einem größeren Strom geladen werden kann als ein Zellverbund 5 mit geringerer Kapazität.

In einfacher Weise kann auch die Art des Ladeverfahrens als historische Betriebsgröße herangezogen werden. Wird ein Zellverbund 5 aus Lithium-Ionen-Zellen regelmäßig nach dem Standardladeverfahren Constant Current/Constant Voltage geladen, hat dies andere Auswirkungen auf die Alterung der Zellen als z. B. ein adaptiertes Pulsladeverfahren hat. So ist vorgesehen, die Häufigkeit der Ausführung eines Ladeverfahrens zu ermitteln und abzuspeichern und aus diesen Werten - ggf. gewichtet - eine historische Betriebsgröße abzuleiten, die zur Bestimmung des Korrekturwertes herangezogen wird.

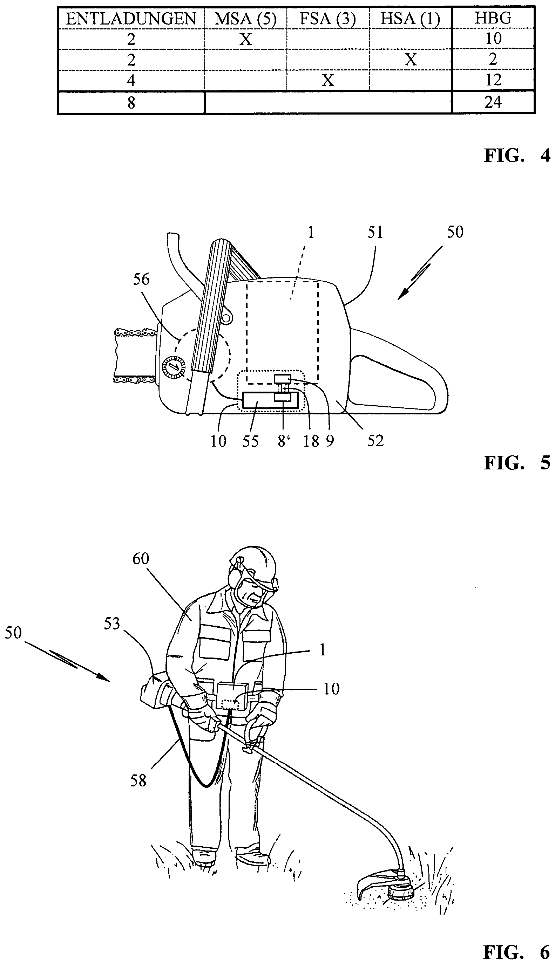

Als historische Betriebsgröße kann auch die Häufigkeit des Betriebs des Akkupacks 1 mit unterschiedlichen elektrischen Arbeitsgeräten 50 abgeleitet werden. Der Betrieb einer Motorsäge 51 (Fig. 5) mit dem Akkupack 1 belastet den Zellverbund 5 deutlich stärker als z. B. der Betrieb mit einem Freischneider 53 (Fig. 6), einem Blasgerät, einer Heckenschere oder dgl. elektrischem Arbeitsgerät. Zweckmäßig wird daher protokolliert und abgespeichert, wie viel Akkuladungen mit einer Akkumotorsäge (MSA), einem Akkufreischneider (FSA) oder einer Akkuheckenschere (HSA) gefahren werden. Fig. 4 zeigt ein Beispiel zur Bildung einer historischen Betriebsgröße HBG unter Berücksichtigung der Verwendung des Akkupacks 1 mit verschiedenen Arbeitsgeräten 50. In der Tabelle ist beispielhaft wiedergegeben, dass ein Akkupack 1 z. B. zwei Akkuladungen mit einer elektrischen Motorsäge, zwei Akkuladungen mit einer elektrischen Heckenschere und vier Akkuladungen mit einem elektrischen Freischneider benutzt wurde. Da die elektrische Belastung des Akkupacks 1 mit der Motorsäge sehr hoch ist, wird die Akkuladung z. B. mit dem Faktor 5 gewichtet, die des Freischneiders mit dem Faktor 3 und die der Heckenschere mit dem Faktor 1 gewichtet. Dadurch ergeben sich historische Betriebsgrößen (HBG) in Abhängigkeit der gewichteten Akkuladungen; im Ausführungsbeispiel nach Fig. 4 ergibt sich aus der Summe der Werte eine durchschnittliche gewichtete historische Betriebsgröße von 3 (HBG = 24:8). Je größer diese historische Betriebsgröße ist, desto stärker erfolgt eine Korrektur der Kennlinie der Debalancierungsgrenze und desto stärker wird die Kennlinie D z. B. in Pfeilrichtung 48 verschoben.

Im gezeigten Ausführungsbeispiel nach Fig. 1 ist die Schutzschaltung 10 vollständig im Gehäuse des Akkupacks 1 aufgenommen; die Auswerteeinheit 8 liegt somit innerhalb des Akkupacks 1, so dass dieser autark in Abhängigkeit der ausgewerteten Zellspannungen ein Abschalten des Akkupacks initiieren kann. Die Anordnung der Schutzschaltung 10 im Akkupack 1 ist z. B. dann vorteilhaft, wenn der Akkupack vom Benutzer 60 getragen ist und über ein Anschlusskabel 58 mit dem elektrischen Arbeitsgerät 50 verbunden ist, wie Fig. 6 zeigt.

Ist der Akkupack 1 in ein Gerätegehäuse 52 eingeschoben, kann die Auswertung der erfassten Zellspannungen $U_{na}$, $U_{nb}$, $U_{nc}$ in einer Auswerteeinheit 8' ausgeführt werden, die z. B. in einer Steuereinheit 55 des Arbeitsgerätes 50 integriert sein kann. Die Steuereinheit 55 steuert den elektrischen Antriebsmotor 56 des Arbeitsgerätes. Die Schutzschaltung 10 wird somit durch die Überwachungsschaltung 9 im Akkupack 1 einerseits und die Auswerteeinheit 8' im Gerätegehäuse 52 anderseits gebildet.

Das bei Überschreiten der Debalancierungsgrenze $U_{Dn}$ von der Schutzschaltung 10 generierte Signal kann in der Steuereinheit 55 derart verarbeitet werden, dass in Abhängigkeit des Auftretens des Signals der Schutzschaltung 10 der Antriebsmotor 56 in anderer Weise angesteuert wird, z. B. mit einem geringeren Strom betrieben wird. Erst wenn die Debalancierungsgrenze $U_{Dn}$ in Abhängigkeit vom Ladezustand SOC des Zellverbundes 5 z. B. mehrfach überschritten wurde, erfolgt eine Abschaltung des Arbeitsgerätes 50 durch die Steuereinheit 55 und/oder ein Öffnen der Schalter 40, 42 im Akkupack über eine Kommunikationsverbindung 18 zwischen dem Akkupack 1 und der Steuereinheit 55.

Auf die Lebensdauer eines Zellverbundes, insbesondere eines Zellverbundes von chemisch auf Lithium basierenden Einzelzellen 2, hat auch einen Einfluss, ob der Zellverbund in Ladezyklen nur teilgeladen oder vollständig geladen wird. Daher ist vorgesehen, eine historische Betriebsgröße als Zyklenverhältnis von Vollladung zur Teilladung zu bilden und dieses in die Korrektur der Kennlinie der Debalancierungsgrenze einfließen zu lassen. Dabei kann die Teilladung eines Zellverbundes etwa 70% bis 90% der Gesamtkapazität, insbesondere aber 80% der Vollladung eines Zellverbundes 5 entsprechen.

Allgemein kann ein Korrekturwert k wie folgt angegeben werden:

$$k = f\,(HBG;\ ABG).$$

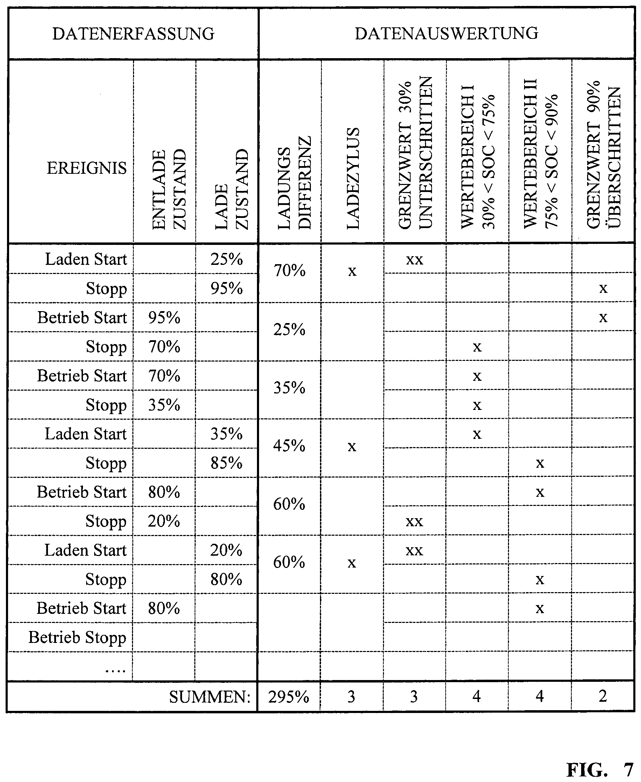

Als zusätzliche oder als weitere Betriebsgröße, die eine aktuelle oder eine historische Betriebsgröße sein kann, wird entsprechend der Darstellung in Fig. 7 der Ladezustand SOCC einer Einzelzelle 2 oder der Ladezustand SOC des Zellverbundes 5 erfasst und abgespeichert. So kann beim Anschließen des Akkupacks 1 an ein Ladegerät der momentane Ladezustand des Zellverbundes 5 erfasst und abgespeichert werden. Nach Zeile 1 der Tabelle ist dieser Ladezustand z. B. 25% SOC (State of Charge); dieser Ladezustand liegt unterhalb eines vorgegebenen unteren Grenzwerts, der z. B. bei 30% angesetzt wird. Auch dieses wird festgehalten und protokolliert.

Nach Abschluss des Ladevorgangs ist der Akkupack auf z. B. 95% SOC aufgeladen; dieser Zustand übersteigt einen vorgegebenen oberen Grenzwert des Ladezustandes von z. B. 90%, weshalb auch dieses Ereignis aufgezeichnet wird.

Der aufgeladene Akkupack 1 wird nun vom Ladegerät getrennt und in Betrieb genommen, z. B. in ein elektrisches Arbeitsgerät 50 (Fig. 5, 6) eingesetzt. Auch hier wird der Ladezustand bei der elektrischen Inbetriebnahme des Akkupacks 1 protokolliert, ebenso wie der Ladezustand zum Ende einer Betriebsdauer des Arbeitsgerätes 50. Entsprechend sind die Werte 90% und 70% als Beispiele in den Zeilen 3 und 4 der Tabelle nach Fig. 7 eingetragen. Bei einem nächsten Betrieb des Arbeitsgerätes 50 werden wieder die Startwerte und Endwerte der Ladezustände erfasst und abgespeichert. Gleiches gilt bei jedem erneuten Ladevorgang. Alle diese Werte werden in geeigneter Weise ausgewertet und zur Bildung einer Betriebsgröße herangezogen.

Eine historische Betriebsgröße HBG kann z. B. dadurch gebildet werden, indem alle geladenen oder entladenen Teilladungen während der Lebenszeit des Akkupacks 1 - z. B. durch Differenzbildung - ermittelt und zu einer Gesamtladungsmenge addiert werden, so dass die Lebensleistung des Akkupacks 1 durch die Gesamtladungsmenge zur Berechnung des Korrekturwertes herangezogen werden kann.

Eine weitere Möglichkeit zur Bildung einer historischen Betriebsgröße ist z. B. die numerische Anzahl der in der Vergangenheit durchgeführten Ladevorgänge, die zweckmäßig in ein Verhältnis zur Gesamtladungsmenge des Akkupacks gesetzt werden kann.

Auch kann auf diese Weise jeweils bei Erfassung des aktuellen Ladezustands festgestellt werden, ob der Ladezustand unterhalb eines vorgegebenen Grenzwertes, in einem ersten Wertebereich I von z. B. 30% < SOC < 75%, in einem zweiten Wertebereich II von z. B. 75% < SOC < 90% oder oberhalb eines Grenzwertes von z. B. 90% SOC liegt. Die jeweils auftretenden Ereignisse können gewichtet werden, um die erhaltenen numerischen Werte zu addieren, zu normieren oder anderweitig zu verarbeiten. Der erhaltene numerische Wert ermöglicht eine Aussage über den Alterungszustand des Zellverbundes und/oder der Einzelzelle, da der erhaltene Wert ein Maß über die geschichtliche Belastung der Einzelzellen bzw. des Zellverbundes ist, was den Alterungsverlauf der im Akkupack verbauten Einzelzellen beeinflusst.

**Patentansprüche**

1. Schutzschaltung für eine Vielzahl von in einem Akkupack (1) angeordneten Einzelzellen (2),

• wobei eine vorgegebene Anzahl von Einzelzellen (2) einen Zellverbund (5) bildet,
• und die Schutzschaltung (10) aus einer Überwachungsschaltung (9) für den Ladezustand der Einzelzellen (2) im Zellverbund (5) und einer Auswerteeinheit (8) umfasst, wobei die Überwachungsschaltung (9) die an einer Einzelzelle (2) anliegende Spannung ($U_{na}$, $U_{nb}$, $U_{nc}$) erfasst und die Auswerteeinheit (8) die erfassten Spannungen ($U_{na}$, $U_{nb}$, $U_{nc}$) mehrerer Einzelzellen (2) untereinander vergleicht,
• um bei Überschreiten einer dem Zellverbund (5) zugeordneten Debalancierungsgrenze ($U_{Dn}$) ein Signal als Steuersignal zum Abschalten des Akkupacks (1) abzugeben,
• wobei die Debalancierungsgrenze ($U_{Dn}$) eine zulässige Spannungsdifferenz ($\Delta U_Z$) zwischen zwei ausgewählten Einzelzellen (2) des Zellverbundes (5) angibt,
• **dadurch gekennzeichnet,**

• **dass** die Debalancierungsgrenze ($U_{Dn}$) des Zellverbundes (5) als über seinen Ladezustand (SOC) variable Kennlinie (D) vorgesehen ist,
• und zur Veränderung der Debalancierungsgrenze ($U_{Dn}$) die Kennlinie (D) in Abhängigkeit eines Korrekturwertes zu verändern ist,
• wobei der Korrekturwert in Abhängigkeit zumindest einer über die Betriebsdauer des Akkupacks (1) erfassten Betriebsgröße des Zellverbundes (5) gebildet ist.

2. Schutzschaltung nach Anspruch 1, **dadurch gekennzeichnet, dass** die Debalancierungsgrenze ($U_{Dn}$) durch die zulässige Differenzspannung ($\Delta U_Z$) zwischen der Spannung ($U_{na}$, $U_{nb}$, $U_{nc}$) der vollsten Einzelzelle (2) und der Spannung ($U_{na}$, $U_{nb}$, $U_{nc}$) der leersten Einzelzelle (2) gebildet wird.

3. Schutzschaltung nach Anspruch 1 oder 2, **dadurch gekennzeichnet, dass** der Korrekturwert in Abhängigkeit mehrerer Betriebsgrößen gebildet ist.

4. Schutzschaltung nach einem der Ansprüche 1 bis 3, **dadurch gekennzeichnet, dass** die Betriebsgröße eine historische Betriebsgröße ist, die aus in der Vergangenheit im Betrieb des Zellverbundes (5) gesammelten historischen Werten gebildet ist.

5. Schutzschaltung nach Anspruch 4, **dadurch gekennzeichnet, dass** die historische Betriebsgröße ein über die Betriebszeit des Zellverbundes (5) gebildetes Lastkollektiv ist.

6. Schutzschaltung nach Anspruch 4 oder 5, **dadurch gekennzeichnet, dass** die historische Betriebsgröße ein über die Betriebszeit des Zellverbundes (5) gebildetes Temperaturkollektiv ist.

7. Schutzschaltung nach einem der Ansprüche 4 bis 6, **dadurch gekennzeichnet, dass** der Zellverbund (5) mit einem Ladestrom ($I_L$) aufgeladen wird und die historische Betriebsgröße aus den vergangenen Ladezeiten mit unterschiedlichen Ladeströmen ($I_L$) gebildet wird und vorzugsweise der erfasste Ladestrom ($I_L$) mit Bezug zur Kapazität des geladenen Zellverbundes (5) normiert wird.

8. Schutzschaltung nach einem der Ansprüche 4 bis 7, **dadurch gekennzeichnet, dass** der Zellverbund (5) mit unterschiedlichen Ladeverfahren aufgeladen wird und die historische Betriebsgröße aus der Häufigkeit der Ausführung eines ersten Ladeverfahrens im Verhältnis zu einem anderen Ladeverfahren gebildet ist.

9. Schutzschaltung nach einem der Ansprüche 4 bis 8,

**dadurch gekennzeichnet, dass** die historische Betriebsgröße aus dem Betrieb des Akkupacks (1) mit unterschiedlichen Arbeitsgeräten (50) abgeleitet wird.

10. Schutzschaltung nach einem der Ansprüche 4 bis 9, **dadurch gekennzeichnet, dass** die historische Betriebsgröße ein Zyklenverhältnis von Vollladungen zur Teilladungen ist, wobei die Teilladung eines Zellverbundes (5) vorzugsweise 70% bis 90%, insbesondere 80% der Vollladung eines Zellverbundes (5) entspricht.

11. Schutzschaltung nach einem der Ansprüche 1 bis 10, **dadurch gekennzeichnet, dass** die Betriebsgröße eine im Momentanbetrieb des Akkupacks erfasste aktuelle Betriebsgröße ist, vorzugsweise der aktuelle Strom ($I_L$) des Zellverbundes (5) oder die aktuelle Temperatur des Zellverbundes (5) ist.

12. Schutzschaltung nach einem der Ansprüche 1 bis 11, **dadurch gekennzeichnet, dass** die Betriebsgröße die in einem Zellverbund (5) oder einer Einzelzelle (2) gespeicherte Ladung (SOC; SOCC) ist, wobei vorzugsweise die über eine Betriebsdauer des Akkupacks (1) ermittelten Ladezustände des Zellverbundes (5) und/oder der Einzelzelle (2) ausgewertet werden.

13. Schutzschaltung nach einem der Ansprüche 1 bis 12, **dadurch gekennzeichnet, dass** das Steuersignal zum Abschalten des gesamten Akkupacks (1) durch einen Schalter (40, 42) herangezogen wird.

14. Schutzschaltung nach einem der Ansprüche 1 bis 13, **dadurch gekennzeichnet, dass** der Zellverbund (5) aus mehreren Zellreihen (A, B, C) aus Einzelzellen (2) besteht und in jeder Zellreihe (A, B, C) ein von der Schutzschaltung (10) gesteuerter Schalter (42), insbesondere ein MOSFET (43) angeordnet ist.

15. Schutzschaltung nach einem der Ansprüche 1 bis 14, **dadurch gekennzeichnet, dass** der Zellverbund (5) mit einem elektrischen Arbeitsgerät (50) verbunden ist, dass das Arbeitsgerät (50) eine Steuereinheit (55) für einen elektrischen Antriebsmotor (56) umfasst und die Steuereinheit (55) in Abhängigkeit des Signals der Schutzschaltung (10) den Antriebsmotor (56) ansteuert.

16. Schutzschaltung nach einem der Ansprüche 1 bis 15, **dadurch gekennzeichnet, dass** die Überwachungsschaltung (9) mit einer Auswerteeinheit (8) verbunden ist, wobei die Auswerteeinheit (8) und die Überwachungsschaltung (9) im Arbeitsgerät (50) angeordnet sind.

17. Schutzschaltung nach einem der Ansprüche 1 bis 16, **dadurch gekennzeichnet, dass** die Einzelzellen (2) chemisch auf Lithium basierende Einzelzellen sind, insbesondere Lithium-Ionen-Zellen sind.

**Claims**

1. Protection circuit for a plurality of individual cells (2) arranged in a battery pack (1),

   • wherein a predefined number of individual cells (2) form a cell composite (5)
   • and the protection circuit (10) is composed of a monitoring circuit (9) for the state of charge of the individual cells (2) in the cell composite (5) and an evaluation unit (8), wherein the monitoring circuit (9) detects the voltage ($U_{na}$, $U_{nb}$, $U_{nc}$) applied to an individual cell (2) and the evaluation unit (8) performs a comparison of the detected voltages ($U_{na}$, $U_{nb}$, $U_{nc}$) of a plurality of individual cells (2),
   • in order to output a signal as a control signal to switch off the battery pack (1) if a de-balancing limit ($U_{Dn}$) assigned to the cell composite (5) is exceeded,
   • wherein the de-balancing limit ($U_{Dn}$) indicates a permissible voltage difference ($\Delta U_Z$) between two selected individual cells (2) of the cell composite (5),
   • **characterised in that**
   • the de-balancing limit ($U_{Dn}$) of the cell composite (5) is provided as a characteristic curve (D) that is variable over its state of charge (SOC),
   • and the characteristic curve (D) is to be changed in dependence upon a correction value, in order to change the de-balancing limit ($U_{Dn}$),
   • wherein the correction value is formed in dependence upon at least one operating variable of the cell composite (5) detected over the operating duration of the battery pack (1).

2. Protection circuit according to claim 1, **characterised in that** the de-balancing limit ($U_{Dn}$) is formed by the permissible voltage difference ($\Delta U_Z$) between the voltage ($U_{na}$, $U_{nb}$, $U_{nc}$) of the fullest individual cell (2) and the voltage ($U_{na}$, $U_{nb}$, $U_{nc}$) of the emptiest individual cell (2).

3. Protection circuit according to claim 1 or 2, **characterised in that** the correction value is formed in dependence upon a plurality of operating variables.

4. Protection circuit according to one of claims 1 to 3, **characterised in that** the operating variable is a historical operating variable, which is formed from historical values collected in the past during operation of the cell composite (5).

5. Protection circuit according to claim 4, **characterised in that** the historical operating variable is a load collective formed over the operating time of the cell composite (5).

6. Protection circuit according to claim 4 or 5, **characterised in that** the historical operating variable is a temperature collective formed over the operating time of the cell composite (5).

7. Protection circuit according to one of claims 4 to 6, **characterised in that** the cell composite (5) is charged with a charging current ($I_L$) and the historical operating variable is formed from the past charging times with different charging currents ($I_L$) and preferably the detected charging current ($I_L$) is standardised with respect to the capacity of the charged cell composite (5).

8. Protection circuit according to one of claims 4 to 7, **characterised in that** the cell composite (5) is charged with different charging processes and the historical operating variable is formed from the frequency of the performance of a first charging process in relation to another charging process.

9. Protection circuit according to one of claims 4 to 8, **characterised in that** the historical operating variable is derived from the operation of the battery back (1) with different work devices (50).

10. Protection circuit according to one of claims 4 to 9, **characterised in that** the historical operating variable is a cycle ratio of full charges to partial charges, wherein the partial charge of a cell composite (5) corresponds preferably to 70% to 90%, in particular to 80%, of the full charge of a cell composite (5).

11. Protection circuit according to one of claims 1 to 10, **characterised in that** the operating variable is a momentary operating variable detected in the momentary operation of the battery pack, preferably the momentary current ($I_L$) of the cell composite (5) or the momentary temperature of the cell composite (5).

12. Protection circuit according to one of claims 1 to 11, **characterised in that** the operating variable is the charge (SOC; SOCC) stored in a cell composite (5) or an individual cell (2), wherein preferably the states of charge of the cell composite (5) and / or the individual cell (2) detected over an operating duration of the battery pack (1) are evaluated.

13. Protection circuit according to one of claims 1 to 12, **characterised in that** the control signal is used to switch off the whole battery pack (1) by means of a switch (40, 42).

14. Protection circuit according to one of claims 1 to 13, **characterised in that** the cell composite (5) is composed of a plurality of cell rows (A, B, C) of individual cells (2) and, in each cell row (A, B, C), a switch (42) controlled by the protection circuit (10), in particular a MOSFET (43), is arranged.

15. Protection circuit according to one of claims 1 to 14, **characterised in that** the cell composite (5) is connected to an electric work device (50), the work device (50) comprises a control unit (55) for an electric drive motor (56), and the control unit (55) controls the drive motor (56) in dependence upon the signal of the protection circuit (10).

16. Protection circuit according to one of claims 1 to 15, **characterised in that** the monitoring circuit (9) is connected to an evaluation unit (8), wherein the evaluation unit (8) and the monitoring circuit (9) are arranged in the work device (50).

17. Protection circuit according to one of claims 1 to 16, **characterised in that** the individual cells (2) are individual cells that are chemically based on lithium, in particular lithium-ion cells.

**Revendications**

1. Circuit protecteur pour un grand nombre d'éléments individuels (2) disposés dans une batterie (1),

   • un nombre prédéfini d'éléments individuels (2) formant un ensemble d'éléments (5),
   • et le circuit protecteur (10) se composant d'un circuit de surveillance (9) pour l'état de charge des éléments individuels (2) dans l'ensemble d'éléments (5), et d'une unité d'évaluation (8), le circuit de surveillance (9) relevant la tension ($U_{na}$, $U_{nb}$, $U_{nc}$) appliquée à un élément individuel (2), et l'unité d'évaluation (8) comparant entre elles les tensions ($U_{na}$, $U_{nb}$, $U_{nc}$) relevées de plusieurs éléments individuels
   • afin d'émettre, en cas de dépassement d'une limite de décompensation ($U_{Dn}$) attribuée à l'ensemble d'éléments (5), un signal comme signal de commande pour arrêter la batterie (1),
   • la limite de décompensation ($U_{Dn}$) indiquant une différence de tension autorisée ($\Delta U_Z$) entre

deux éléments individuels (2) sélectionnés de l'ensemble d'éléments (5),
**caractérisé**
• **en ce que** la limite de décompensation ($U_{Dn}$) de l'ensemble d'éléments (5) est prévue sous la forme d'une courbe caractéristique (D) variable sur son état de charge (SOC),
• et pour modifier la limite de décompensation ($U_{Dn}$), la courbe caractéristique (D) doit être modifiée en fonction d'une valeur de correction,
• la valeur de correction étant formée en fonction d'au moins une grandeur de fonctionnement de l'ensemble d'éléments (5) relevée sur la durée de fonctionnement de la batterie (1).

2. Circuit protecteur selon la revendication 1, **caractérisé en ce que** la limite de décompensation ($U_{Dn}$) est formée par la tension différentielle ($\Delta U_Z$) entre la tension ($U_{na}$, $U_{nb}$, $U_{nc}$) de l'élément individuel (2) le plus plein et la tension ($U_{na}$, $U_{nb}$, $U_{nc}$) de l'élément individuel (2) le plus vide.

3. Circuit protecteur selon la revendication 1 ou 2, **caractérisé en ce que** la valeur de correction est formée en fonction de plusieurs grandeurs de fonctionnement.

4. Circuit protecteur selon l'une des revendications 1 à 3, **caractérisé en ce que** la grandeur de fonctionnement est une grandeur de fonctionnement historique qui est formée à partir de valeurs historiques recueillies par le passé lors du fonctionnement de l'ensemble d'éléments (5).

5. Circuit protecteur selon la revendication 4, **caractérisé en ce que** la grandeur de fonctionnement historique est un collectif de charge formé sur la durée de fonctionnement de l'ensemble d'éléments (5).

6. Circuit protecteur selon la revendication 4 ou 5, **caractérisé en ce que** la grandeur de fonctionnement historique est un collectif de température formé sur la durée de fonctionnement de l'ensemble d'éléments (5).

7. Circuit protecteur selon l'une des revendications 4 à 6, **caractérisé en ce que** l'ensemble d'éléments (5) est chargé avec un courant de charge ($I_L$), et la grandeur de fonctionnement historique est formée à partir des temps de charge passés avec différents courants de charge ($I_L$), et de préférence le courant de charge ($I_L$) relevé est normalisé par rapport à la capacité de l'ensemble d'éléments (5) chargé.

8. Circuit protecteur selon l'une des revendications 4 à 7, **caractérisé en ce que** l'ensemble d'éléments (5) est chargé avec différents procédés de charge, et la grandeur de fonctionnement historique est formée à partir de la fréquence de l'exécution d'un premier procédé de charge par rapport à un autre procédé de charge.

9. Circuit protecteur selon l'une des revendications 4 à 8, **caractérisé en ce que** la grandeur de fonctionnement historique est dérivée du fonctionnement de la batterie (1) avec différents appareils de travail (50).

10. Circuit protecteur selon l'une des revendications 4 à 9, **caractérisé en ce que** la grandeur de fonctionnement historique est un rapport cyclique de pleines charges et de charges partielles, la pleine charge d'un ensemble d'éléments (5) correspondant de préférence à 70% à 90%, en particulier à 80% de la pleine charge d'un ensemble d'éléments (5).

11. Circuit protecteur selon l'une des revendications 1 à 10, **caractérisé en ce que** la grandeur de fonctionnement est une grandeur de fonctionnement actuelle relevée lors du fonctionnement momentané de la batterie, de préférence le courant actuel ($I_L$) de l'ensemble d'éléments (5) ou la température actuelle de l'ensemble d'éléments (5).

12. Circuit protecteur selon l'une des revendications 1 à 11, **caractérisé en ce que** la grandeur de fonctionnement est la charge (SOC; SOCC) accumulée dans un ensemble d'éléments (5) ou dans un élément individuel (2), les états de charge de l'ensemble d'éléments (5) et/ou de l'élément individuel (2) déterminés sur une durée de fonctionnement de la batterie (2) étant de préférence évalués.

13. Circuit protecteur selon l'une des revendications 1 à 12, **caractérisé en ce que** le signal de commande est utilisé pour arrêter toute la batterie (2) grâce à un commutateur (40, 42).

14. Circuit protecteur selon l'une des revendications 1 à 13, **caractérisé en ce que** l'ensemble d'éléments (5) se compose de plusieurs rangées (A, B, C) d'éléments individuels (2), et dans chaque rangée d'éléments (A, B, C) est disposé un commutateur (42), en particulier un MOSFET (43), commandé par le circuit protecteur (10).

15. Circuit protecteur selon l'une des revendications 1 à 14,

**caractérisé en ce que** l'ensemble d'éléments (5) est relié à un appareil de travail électrique (50), **en ce que** l'appareil de travail (50) comprend une unité de commande pour un moteur d'entraînement électrique (56), et l'unité de commande (55) commande le moteur d'entraînement (3) en fonction du signal du circuit protecteur (10).

16. Circuit protecteur selon l'une des revendications 1 à 15,

   **caractérisé en ce que** le circuit de surveillance (9) est relié à une unité d'évaluation (8), l'unité d'évaluation (8) et le circuit de surveillance (9) étant disposés dans l'appareil de travail (50).

17. Circuit protecteur selon l'une des revendications 1 à 16,

   **caractérisé en ce que** les éléments individuels (2) sont des éléments individuels chimiquement à base de lithium, en particulier des éléments lithium-ion.

**FIG. 1**

FIG. 2

FIG. 3

| ENTLADUNGEN | MSA (5) | FSA (3) | HSA (1) | HBG |
|:---:|:---:|:---:|:---:|:---:|
| 2 | X | | | 10 |
| 2 | | | X | 2 |
| 4 | | X | | 12 |
| 8 | | | | 24 |

FIG. 4

FIG. 5

FIG. 6

| DATENERFASSUNG | | | DATENAUSWERTUNG | | | | | |
|---|---|---|---|---|---|---|---|---|
| EREIGNIS | ENTLADE ZUSTAND | LADE ZUSTAND | LADUNGS DIFFERENZ | LADEZYLUS | GRENZWERT 30% UNTERSCHRITTEN | WERTEBEREICH I 30% < SOC < 75% | WERTEBEREICH II 75% < SOC < 90% | GRENZWERT 90% ÜBERSCHRITTEN |
| Laden Start | | 25% | 70% | x | xx | | | |
| Stopp | | 95% | | | | | | x |
| Betrieb Start | 95% | | 25% | | | | | x |
| Stopp | 70% | | | | | x | | |
| Betrieb Start | 70% | | 35% | | | x | | |
| Stopp | 35% | | | | | x | | |
| Laden Start | | 35% | 45% | x | | x | | |
| Stopp | | 85% | | | | | x | |
| Betrieb Start | 80% | | 60% | | | | x | |
| Stopp | 20% | | | | xx | | | |
| Laden Start | | 20% | 60% | x | xx | | | |
| Stopp | | 80% | | | | | x | |
| Betrieb Start | 80% | | | | | | x | |
| Betrieb Stopp | | | | | | | | |
| …. | | | | | | | | |
| SUMMEN: | | | 295% | 3 | 3 | 4 | 4 | 2 |

**FIG. 7**

15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011068744 A1